# EUROPEAN PATENT APPLICATION

(11) **EP 2 263 885 A1**
(43) Date of publication of application: **22.12.2010**
(21) Application number: 09719158.9
(22) Date of filing: 17.02.2009
(51) Int. Cl.: B41N 3/08, G03F 7/00, G03F 7/11, G03F 7/40

(54) **METHOD FOR MAKING LITHOGRAPHIC PRINTING ORIGINAL PLATE**

(30) Priority: 14.03.2008 JP 2008066280
(71) Applicant: Eastman Kodak Company, Rochester, NY 14650 (US)
(72) Inventor: HOTATE, Shouichi, Oura-gun Gunma 370-0723 (JP); KUMAZUMI, Satoko, Oura-gun Gunma 370-0723 (JP); MIYAMOTO, Yasushi, Oura-gun Gunma 370-0723 (JP); ABURANO, Maru, Oura-gun Gunma 370-0723 (JP); HAYAKAWA, Eiji, Oura-gun Gunma 370-0723 (JP)
(74) Representative: Vossius & Partner
(86) International application number: PCT/JP2009/053122
(87) International publication number: WO 2009/113378

(57) **Abstract**

An object of the present invention is to provide a method for plate-making of a lithographic printing original plate having excellent restart toning recovery properties, and particularly an infrared-sensitive positive working lithographic printing original plate.

The present invention relates to a method for plate-making of a lithographic printing original plate comprising an intermediate layer containing a polymer having a phosphonic acid group or a phosphoric acid group disposed between a substrate and an image recording layer, the method comprising the steps of image-wise exposing the lithographic printing original plate, developing, and treating using a plate surface protective solution containing a starch having an onium group.

## Description

### TECHNICAL FIELD

The present invention relates to a method for plate-making of a lithographic printing original plate, and in particular a method for plate-making of a lithographic printing original plate comprising an intermediate layer containing a polymer having a phosphonic acid group or a phosphoric acid group.

### BACKGROUND ART

Heretofore, as a lithographic printing original plate, a lithographic printing original plate comprising a photosensitive image recording layer (PS plate) has been known. The PS plate basically includes two kinds of plates, a negative working plate and a positive working plate. When a negative working plate is used, the plate is exposed using a negative film and is developed with a developing solution for a negative working plate, and then an image recording layer in unexposed areas is removed to form non-image areas. When a positive working plate is used, the plate is exposed using a positive film and is developed with a developing solution for a positive working plate, and then an image recording layer in exposed areas solubilized by exposure is removed to form non-image areas.

With the progress of computer image processing technology, a method for writing an image directly on an image recording layer by means of photoirradiation based on digital signals has been recently developed. A computer-to-plate (CTP) system has attracted considerable attention in which a lithographic printing original plate forms an image directly on the photosensitive printing plate without outputting the image onto a silver salt mask film. A CTP system using high power lasers having maximum strength in a near infrared or infrared region as a light source for photoirradiation has various advantages. For example, a high resolution image can be produced with a short period of exposure, and a photosensitive lithographic printing plate material used for this method may be handled in a normally lit room. Particularly, solid state and high power lasers such as solid state and semiconductor lasers capable of emitting infrared rays having a wavelength of 760 nm to 1,200 nm can have been easily obtained.

Photosensitive positive working lithographic printing plate in which an image can be formed by exposure using a solid state or semiconductor laser capable of emitting infrared rays, followed by a development treatment with a developing solution, for example, include a lithographic printing plate comprising a image recording layer of a positive photosensitive composition which contains a water-insoluble and alkali-soluble resin (novolak resin, etc.) and a photothermal conversion agent (infrared absorber such as dye, pigment, etc.) and enables an increase in solubility in an aqueous alkali solution by heating.

Although a substrate having a hydrophilic surface is used in the lithographic printing original plate, a substrate whose surface is subjected to a hydrophilization treatment, such as a polyvinylphosphonic acid treatment, so as to further enhance hydrophilicity is often used. It is known that when such a hydrophilic intermediate layer is disposed between a substrate and an image recording layer, a lithographic printing plate capable of obtaining a printed matter free from smearing upon printing can be obtained. However, various smears may still occur depending to materials (paper, ink, dampening-water, etc.) and printing conditions in the printing plate, and it is necessary to prevent "restart toning".

Restart toning means a smear caused when restarting printing after stopping printing. In a printing site, after a lithographic printing plate is mounted on a printing machine and printing is initiated, printing is sometimes suspended during lunch breaks or when an operation requiring stopping the printing machine is carried out, etc. In that case, the printing plate is normally allowed to remain on the printing machine with ink adhered to the surface of the plate, and then printing is restarted. Upon restarting of the printing, a smear sometimes occurs in non-image areas, which is called restart toning.

Japanese Unexamined Patent Publication (Kokai) No. 2003-255563 describes that, in order to prevent smearing upon printing, a substrate having a hydrophilic surface on which a hydrophilic graft polymer chain exists is subjected to a plate surface protective treatment using a plate surface protective agent containing at least one kind of a water-soluble cationic resin. However, this patent publication discloses no recognition of a problem of restart toning of a positive working lithographic printing plate since there is no description concerning restart toning.

Japanese Unexamined Patent Publication (Kokai) No. 2003-066621 describes that, in order to prevent smearing upon printing, after developing with a developing solution for a photopolymerization type photosensitive lithographic printing plate, which has pH of 11.5 or higher and 12.8 or lower and electric conductivity of 3 to 40 mS/cm, a printing plate is treated with a desensitizing agent containing gum arabic and modified starch. Although print smearing caused when allowing the plate to remain on the printing machine (restart toning) is evaluated, an intermediate layer of a lithographic printing original plate used herein is made of an organic compound having a phosphoric acid group or a phosphonic acid group and is free from film-forming ability.

Japanese Unexamined Patent Publication (Kokai) No. 04-303839 describes a method for producing a lithographic printing plate in which a negative photosensitive lithographic printing plate is developed with an alkali developing solution containing no organic solvent and is desensitized with a water-soluble desensitizing solution, and does not cause print smearing. However, this patent publication discloses no recognition of a problem of restart toning of a positive working lithographic printing plate since there is no description concerning restart toning.

### DISCLOSURE OF THE INVENTION

The present inventors have intensively researched and found that when an intermediate layer containing a polymer having a phosphonic acid group or a phosphoric acid group is disposed between a substrate and an image recording layer of a lithographic printing original plate, ink clean-up (removal) characteristics are inferior and restart toning is likely to occur, although smearing upon continuous printing noticeably decreases.

An object of the present invention is to provide a method for plate-making of a lithographic printing original plate having satisfactory restart toning recovery properties, particularly an infrared-sensitive positive working lithographic printing original plate.

In order to achieve the above object, the present inventors have further researched and found that, when a lithographic printing original plate comprising the above intermediate layer, particularly an infrared-sensitive positive working lithographic printing plate is treated with a plate surface protective solution containing a starch having an onium group, restart toning noticeably decreases.

Thus, the present invention provides a method for plate-making of a lithographic printing original plate comprising an intermediate layer containing a polymer having a phosphonic acid group or a phosphoric acid group disposed between a substrate and an image recording layer, the method comprising image-wise exposing the lithographic printing original plate, developing, and treating using a plate surface protective solution containing a starch having an onium group.

### EFFECT OF THE INVENTION

According to the method for plate-making of a plate of the present invention, a method for plate-making of a photosensitive lithographic printing original plate having satisfactory restart toning recovery properties can be provided. A plate can be directly plate-made based on digital information of a computer and a lithographic printing plate having excellent print smearing resistance can be provided.

### BEST MODE FOR CARRYING OUT THE INVENTION

The lithographic printing original plate used in the present invention comprises a substrate, and an intermediate layer and an image recording layer disposed on the substrate.

### <Substrate>

Examples of the substrate include metal plates made of aluminum, zinc, copper, stainless steel and iron; plastic films made of polyethylene terephthalate, polycarbonate, polyvinyl acetal and polyethylene; paper melt-coated with a synthetic resin or coated with a synthetic resin solution, and composite materials obtained by forming a metal layer on a plastic film through a technique such as vacuum deposition or laminate; and materials used as the substrate of the printing plate. Of these substrates, aluminum and a composite substrate coated with aluminum are particularly preferred.

The surface of the aluminum substrate is preferably subjected to a surface treatment for the purpose of enhancing water retentivity and improving adhesion with a bottom layer or an intermediate layer which is optionally disposed. The surface treatment includes, for example, roughening treatments such as a brush graining method, a ball graining method, electrolytic etching, chemical etching, liquid honing and sand blasting, and a combination thereof. Of these surface treatments, a roughening treatment including use of electrolytic etching is particularly preferred.

In the electrolytic bath used in the case of electrolytic etching, an aqueous solution containing an acid, an alkali or a salt thereof, or an aqueous solution containing an organic solvent is used. Of these solutions, an electrolytic solution containing hydrochloric acid, nitric acid or a salt thereof is particularly preferred.

Furthermore, the aluminum substrate subjected to the roughening treatment is optionally desmutted with an aqueous solution of an acid or an alkali. The aluminum substrate thus obtained is preferably subjected to an anodizing treatment. An anodizing treatment of treating using a bath containing sulfuric acid or phosphoric acid is particularly preferred.

It is also possible to carry out a silicate treatment (sodium silicate, potassium silicate), a potassium fluorozirconate treatment, a phosphomolybdate treatment, an alkyltitanate treatment, a polyacrylic acid treatment, a phytic acid treatment, a treatment with a salt of a hydrophilic organic polymer compound and a divalent metal, a condensed arylsulfonate treatment, a hydrophilization treatment by undercoating of a water-soluble polymer having a sulfonic acid group, a coloration treatment with an acid dye, and silicate electrodeposition.

An aluminum substrate subjected to a sealing treatment after subjecting to a roughening treatment (graining treatment) and an anodizing treatment is also preferred. The sealing treatment is carried out by immersion of an aluminum substrate in hot water, and a hot water solution containing an inorganic salt or an organic salt, or a steam bath.

### <Intermediate Layer>

The lithographic printing original plate of the present invention includes an intermediate layer between the substrate and the image recording layer. The intermediate layer comprises a polymer having a phosphonic acid group or a phosphoric acid group.

The polymer having a phosphonic acid group includes a homopolymer of vinylphosphonic acid, or a copolymer of vinylphosphonic acid. Examples of the homopolymer of vinylphosphonic acid include polyvinylphosphonic acid, and examples of the copolymer of vinylphosphonic acid include a copolymer of vinylphosphonic acid and (meth)acrylic acid.

When polyvinylphosphonic acid is used, the substrate is usually treated by immersing in an aqueous solution of 0.1 to 30 g/L of polyvinylphosphonic acid at 20 to 90°C for 2 to 120 seconds.

When the copolymer of vinylphosphonic acid and (meth)acrylic acid is used, a monomer ratio of a vinylphosphonic acid moiety to a (meth)acrylic acid moiety is preferably within a range from 9:1 to 1:9. When a copolymer is used, it is used as an aqueous solution of 0.1 to 30 g/L.

Examples of a polymer having a phosphoric acid group are polymers including monomers such as ethylene glycol acrylate phosphate, ethylene glycol methacrylate phosphate, polyethylene glycol acrylate phosphate, polyethylene glycol methacrylate phosphate, polypropylene glycol acrylate phosphate and polypropylene glycol methacrylate phosphate.

These monomers are commercially available under the trade name "Phosmer" and have the structures shown below.

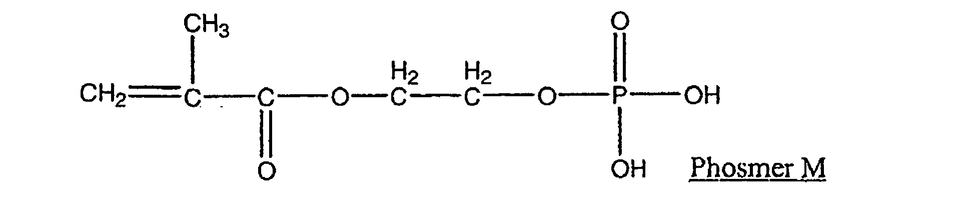

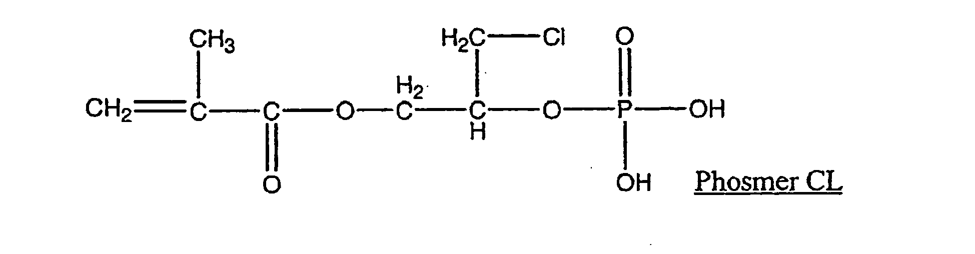

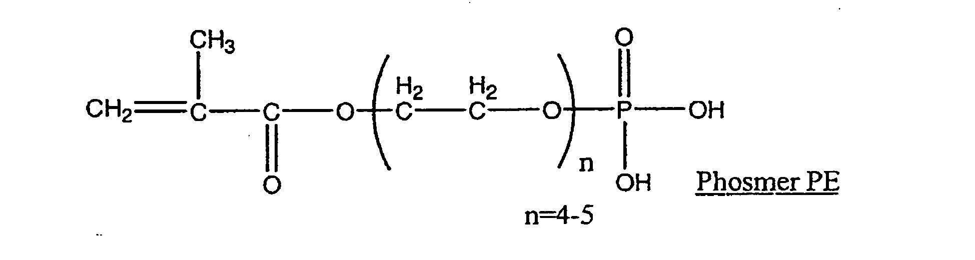

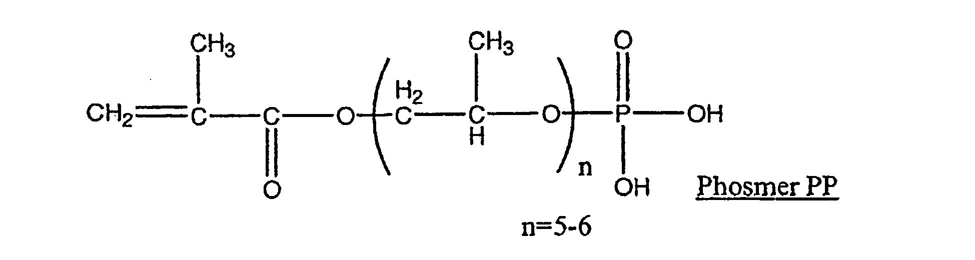

The intermediate layer can be disposed on the substrate by various methods, in addition to the above immersion treatment. For example, any method such as bar coater coating, spin coating, spray coating or curtain coating can be used. The amount of the intermediate layer disposed on the substrate is preferably from 1 to 50 mg/m², and particularly preferably from 2 to 40 mg/m².

The intermediate layer can contain, in addition to the above components, aluminum sulfate.

### <Image Recording Layer>

The image recording layer constituting the lithographic printing plate of the present invention may be a single layer, or may have a two-layered structure comprising a first image recording layer and a second image recording layer disposed thereon. The image recording layer may be a layer containing a positive photosensitive composition or a negative photosensitive composition.

It is preferred to use, as the positive photosensitive composition, known conventional positive photosensitive compositions [(a) to (d)] shown below.
(a) Conventionally used positive photosensitive compositions comprising quinonediazide and a novolak resin.
(b) Infrared-sensitive positive compositions containing a resin which is water-insoluble and is soluble or dispersible in an aqueous alkali solution, and a photothermal conversion agent, and enables enhanced solubility in the aqueous alkali solution by an action of heat.
(c) Infrared-sensitive positive compositions comprising a heat-decomposable sulfonate ester polymer or an acid-decomposable carboxylate ester polymer, and an infrared absorber.
(d) Chemically amplified positive photosensitive compositions comprising a combination of an alkali-soluble compound protected with an acid-decomposable group, and an acid generator.

It is possible to use, as the negative photosensitive composition, known conventional negative photosensitive compositions ((g) to (j)) shown below.
(g) Negative photosensitive compositions comprising a polymer having a photocrosslinkable group, and an azide compound.
(h) Negative photosensitive compositions comprising a diazo compound.
(i) Photo- or thermpolymerizable negative photosensitive compositions comprising a photo- or thermopolymerization initiator, an addition-polymerizable unsaturated compound and an alkali-soluble polymer compound.
(j) Negative photosensitive compositions comprising an alkali-soluble polymer compound, an acid generator and an acid-crosslinkable compound.

A layer comprising an infrared-sensitive positive composition is preferred. An infrared-sensitive positive working lithographic printing original plate comprising a first image recording layer and a second image recording layer is more preferred.

### <First Image Recording Layer>

The first image recording layer constituting the lithographic printing original plate contains a resin which is soluble or dispersible in an aqueous alkali solution.

Since the resin is soluble or dispersible in the aqueous alkali solution, the resin preferably has a least a functional group such as a hydroxyl group, a carboxyl group, a sulfonic acid group, a phosphoric acid group, an imide group or an amide group. Therefore, the resin soluble or dispersible in the aqueous alkali solution can be appropriately produced by polymerizing a monomer mixture containing one or more ethylenically unsaturated monomers having a functional group such as a hydroxyl group, a carboxyl group, a sulfonic acid group, a phosphoric acid group, an imide group, an amide group, or a combination thereof.

The ethylenically unsaturated monomer can be formed into a compound represented by the following formula: 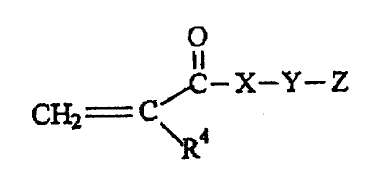 wherein R⁴ represents a hydrogen atom, a C₁₋₂₂ linear, branched or cyclic alkyl group, a C₁₋₂₂ linear, branched or cyclic substituted alkyl group, a C₆₋₂₄ aryl group, or a substituted aryl group and the substituent is selected from a C₁₋₄ alkyl group, an aryl group, a halogen atom, a keto group, an ester group, an alkoxy group and a cyano group; X represents O, S or NR⁵ in which R⁵ represents hydrogen, a C₁₋₂₂ linear, branched or cyclic alkyl group, a C₁₋₂₂ linear, branched or cyclic substituted alkyl group, a C₆₋₂₄ aryl group, or a substituted aryl group and the substituent is selected from a C₁₋₄ alkyl group, an aryl group, a halogen atom, a keto group, an ester group, an alkoxy group and a cyano group; Y represents a single bond or a C₁₋₂₂ linear, branched or cyclic alkylene, alkyleneoxyalkylene, poly(alkyleneoxy)alkylene, or alkylene-NHCONH-; and Z represents a hydrogen atom, a hydroxy group, carboxylic acid, -C₆H₄-SO₂NH₂, -C₆H₃-SO₂NH₂(-OH), or a group represented by the following formula: 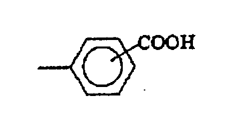 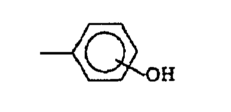 or 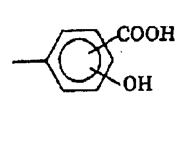 or a mixture thereof.

Examples of the ethylenically unsaturated monomer include, in addition to, acrylic acid and methacrylic acid, a compound represented by the following formula, and a mixture thereof.

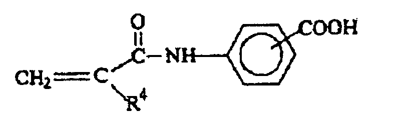

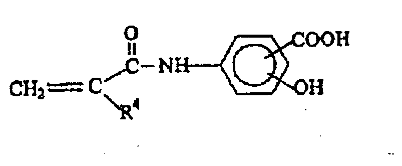

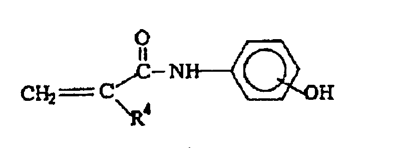

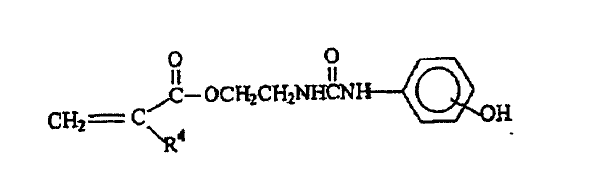

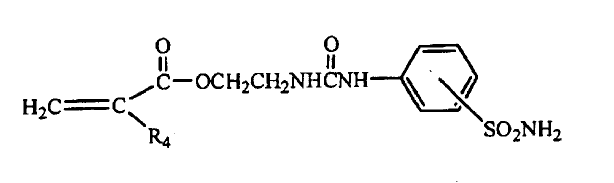

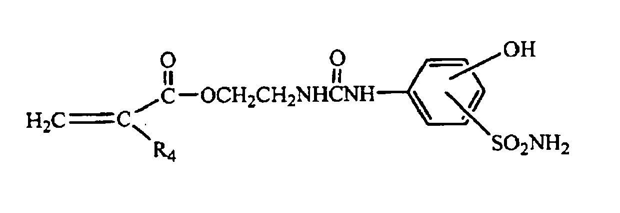

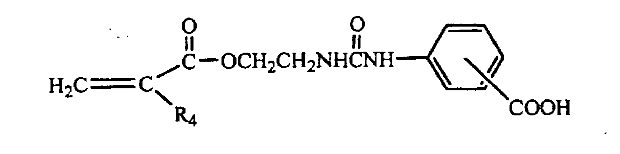

The monomer mixture may contain the other ethylenically unsaturated comonomer. Examples of the other ethylenically unsaturated comonomer include monomers shown below, for example:
acrylate esters such as methyl acrylate, ethyl acrylate, propyl acrylate, butyl acrylate, amyl acrylate, ethylhexyl acrylate, octyl acrylate, t-octyl acrylate, chloroethyl acrylate, 2,2-dimethylhydroxypropyl acrylate, 5-hydroxypentyl acrylate, trimethylolpropane monoacrylate, pentaerythritol monoacrylate, glycidyl acrylate, benzyl acrylate, methoxybenzyl acrylate and tetrahydro acrylate;
aryl acrylates such as phenyl acrylate and furfuryl acrylate;
methacrylate esters such as methyl methacrylate, ethyl methacrylate, propyl methacrylate, isopropyl methacrylate, allyl methacrylate, amyl methacrylate hexyl methacrylate, cyclohexyl methacrylate, benzyl methacrylate, chlorobenzyl methacrylate, octyl methacrylate, 4-hydroxybutyl methacrylate, 5-hydroxypentyl methacrylate, 2,2-dimethyl-3-hydroxypropyl methacrylate, trimethylolpropane monomethacrylate, pentaerythritol monomethacrylate, glycidyl methacrylate, furfuryl methacrylate and tetrahydrofurfuryl methacrylate;
aryl methacrylates such as phenyl methacrylate, cresyl methacrylate and naphthyl methacrylate;
N-alkylacrylamides such as N-methylacrylamide, N-ethylacrylamide, N-propylacrylamide, N-butylacrylamide, N-t-butylacrylamide, N-heptylacrylamide, N-octylacrylamide, N-cyclohexylacrylamide and N-benzylacrylamide;
N-arylacrylamides such as N-phenylacrylamide, N-tolylacrylamide, N-nitrophenylacrylamide, N-naphthylacrylamide and N-hydroxyphenylacrylamide; N,N-dialkylacrylamides such as N,N-dimethylacrylamide, N,N-diethylacrylamide, N,N-dibutylacrylamide, N,N-dibutylacrylamide, N,N-diisobutylacrylamide, N,N-diethylhexylacrylamide and N,N-dicyclohexylacrylamide; N,N-arylacrylamides such as N-methyl-N-phenylacrylamide, N-hydroxyethyl-N-methylacrylamide and N-2-acetoamideethyl-N-acetylacrylamide;
N-alkylmethacrylamides such as N-methylmethacrylamide, N-ethylmethacrylamide, N-propylmethacrylamide, N-butylmethacrylamide, N-t-butylmethacrylamide, N-ethylhexylmethacrylamide, N-hydroxyethylmethacrylamide and N-cyclohexylmethacrylamide;
N-arylmethacrylamides such as N-phenylmethacrylamide and N-naphthylmethacrylamide;
N,N-dialkylmethacrylamides such as N,N-diethylmethacrylamide, N,N-dipropylmethacrylamide and N,N-dibutylmethacrylamide;
N,N-diarylmethacrylamides such as N,N-diphenylmethacrylamide;
methacrylamide derivatives such as N-hydroxyethyl-N-methylmethacrylamide, N-methyl-N-phenylmethacrylamide and N-ethyl-N-phenylmethacrylamide;
allyl compounds such as allyl acetate, allyl caproate, allyl caprylate, allyl laurate, allyl palmitate, allyl stearate, allyl benzoate allyl acetoacetate, allyl lactate and allyloxyethanol;
vinyl ethers such as hexyl vinyl ether, octyl vinyl ether, dodecyl vinyl ether, ethylhexyl vinyl ether, methoxyethyl vinyl ether, ethoxyethyl vinyl ether, chloroethyl vinyl ether, 1-methyl-2,2-dimethylpropyl vinyl ether, 2-ethylbutyl vinyl ether, hydroxyethyl vinyl ether, diethylene glycol vinyl ether, dimethylaminoethyl vinyl ether, diethylaminoethyl vinyl ether, butylaminoethyl vinyl ether, benzyl vinyl ether, tetrahydrofurfuryl vinyl ether, vinyl phenyl ether, vinyl tolyl ether, vinyl chlorophenyl ether, vinyl-2,4-dichlorophenyl ether, vinyl naphthyl ether and vinyl anthranyl ether;
vinyl esters such as vinyl butyrate, vinyl isobutyrate, vinyl trimethylacetate, vinyl diethylacetate, vinyl valeate, vinyl caproate, vinyl chloroacetate, vinyl methoxyacetate, vinyl butoxyacetate, vinyl phenylacetate, vinyl acetoacetate, vinyl lactate, vinyl-β-phenylbutyrate, vinyl cyclohexylcarboxylate, vinyl benzoate, vinyl salicylate, vinyl chlorobenzoate, vinyl tetrachlorobenzoate and vinyl naphthoate;
styrenes such as styrene, methylstyrene, dimethylstyrene, trimethylstyrene, ethylstyrene, diethylstyrene, isopropylstyrene, butylstyrene, hexylstyrene, cyclohexylstyrene, dodecylstyrene, benzylstyrene, chloromethylstyrene, trifluoromethylstyrene, ethoxymethylstyrene, acetoxymethylstyrene, methoxystyrene, 4-methoxy-3-methylstyrene, dimethoxystyrene, chlorostyrene, dichlorostyrene, trichlorostyrene, tetrachlorostyrene, pentachlorostyrene, bromostyrene, dibromostyrene, iodostyrene, fluorostyrene, 2-bromo-4-trifluoromethylstyrene and 4-fluoro-3-trifluoromethylstyrene;
crotonate esters such as butyl crotonate, hexyl crotonate, crotonic acid and glycerin monocrotonate; dialkyl itaconates such as dimethyl itaconate, diethyl itaconate and dibutyl itaconate;
dialkyls of maleic acid or fumaric acid, such as dimethyl maleate and dibutyl maleate;
maleimides such as N-methylmaleimide, N-ethylmaleimide, N-propylmaleimide, N-butylmaleimide, N-phenylmaleimide, N-2-methylphenylmaleimide, N-2,6-diethylphenylmaleimide, N-2-chlorophenylmaleimide, N-cyclohexylmaleimide, N-laurylmaleimide and N-hydroxyphenylmaleimide; and other nitrogen atom-containing monomers such as N-vinylpyrrolidone, N-vinylpyridine, acrylonitrile and methacrylonitrile.

Of these other ethylenically unsaturated comonomers, for example, (meth)acrylate esters, (meth)acrylamides, maleimides and (meth)acrylonitriles are preferably used.

The content of the resin, which is a soluble or dispersible resin in the aqueous alkali solution, in the first image recording layer is preferably within a range from 20 to 95% by mass, based on the solid content. When the content of the resin soluble or dispersible resin in the aqueous alkali solution is less than 20% by mass, it is disadvantageous in view of chemical resistance. In contrast, when the content is more than 95% by mass, it is not preferred in view of exposure speed. If necessary, two or more kinds of resins soluble or dispersible resin in the aqueous alkali solution may be used in combination.

### <Second Image Recording Layer>

The second image recording layer constituting the lithographic printing original plate of the present invention contains an alkali-soluble resin. The alkali-soluble resin which can be used in the second image recording layer is preferably a resin having a carboxylic acid group or an acid anhydride group and examples thereof include a copolymer obtained by polymerizing a monomer mixture containing an unsaturated carboxylic acid and/or an unsaturated carboxylic acid anhydride, and a polyurethane having a substituent containing an acidic hydrogen atom. Examples of the unsaturated carboxylic acid and/or unsaturated carboxylic acid anhydride include acrylic acid, methacrylic acid, maleic acid, maleic anhydride, itaconic acid and itaconic anhydride. Examples of the copolymerizable ethylenically unsaturated monomer unit include other ethylenically unsaturated combnomers.

In the polyurethane having a substituent containing an acidic hydrogen atom, the acidic hydrogen atom can belong to an acidic functional group such as carboxyl group, -SO₂NHCOO- group, -CONHSO₂- group, -CONHSO₂NH-group or -NHCONHSO₂- group, and an acidic hydrogen atom derived from a carboxyl group is particularly preferred.

The polyurethane containing an acidic hydrogen atom can be synthesized by, for example, a method of reacting a diol having a carboxyl group and, if necessary the other diol, and a diisocyanate; a method of reacting a diol, a diisocyanate having a carboxyl group and, if necessary the other diisocyanate; or a method of reacting a diol having a carboxyl group and, if necessary the other diol, a diisocyanate having a carboxyl group and, if necessary the other diisocyanate.

Examples of the diol having a carboxyl group include 3,5-dihydroxybenzoic acid, 2,2-bis(hydroxymethyl)propionic acid, 2,2-bis(hydroxyethyl)propionic acid, 2,2-bis(3-hydroxypropylpropionic acid, 2,2-bis(hydroxymethyl)acetic acid, bis-(4-hydroxyphenyl)acetic acid, 4,4-bis-(4-hydroxyphenyl)pentanoic acid and tartaric acid. Of these diols, 2,2-bis(hydroxymethyl)propionic acid is particularly preferred in view of reactivity with the isocyanate.

Examples of the other diol include dimethylolpropane, polypropylene glycol, neopentyl glycol, 1,3-propanediol, polytetramethylene ether glycol, polyesterpolyol, polymerpolyol, polycaprolactonepolyol, polycarbonatediol, 1,4-butanediol, 1,5-pentadiol, 1,6-hexanediol and polybutadienepolyol.

Examples of the diisocyanate having a carboxyl group include dimer acid diisocyanate.

Examples of the other diisocyanate include 4,4'-diphenylmethane diisocyanate, xylylene diisocyanate, naphthylene-1,5-diisocyanate, tetramethylxylene diisocyanate, hexamethylene diisocyanate, toluene-2,4-diisocyanate, isophorone diisocyanate, hydrogenated xylylene diisocyanate, dicyclohexylmethane diisocyanate, norbornene diisocyanate and trimethylhexamethylene diisocyanate.

The molar ratio of the diisocyanate to the diol is preferably from 0.7:1 to 1.5:1. When there is a residual isocyanate group at the polymer end, synthesis is carried out by treating with alcohols or amines so that the isocyanate group does not finally remain.

The weight average molecular weight of the copolymer including an unsaturated carboxylic acid unit and/or an unsaturated carboxylic acid anhydride unit is preferably within a range from 800 to 10,000. When the weight average molecular weight of the copolymer including an unsaturated carboxylic acid unit and/or an unsaturated carboxylic acid anhydride unit is less than 800, developing solution resistance tends to be inferior because of the weak image areas obtained by image formation. In contrast, when the weight average molecular weight of the copolymer including an unsaturated carboxylic acid unit and/or an unsaturated carboxylic acid anhydride unit is more than 10,000, sensitivity tends to be inferior.

The weight average molecular weight of the polyurethane having a substituent including an acidic hydrogen atom is preferably within a range from 2,000 to 100,000. When the weight average molecular weight of the polyurethane is less than 2,000, press life tends to be inferior because of the weak image areas obtained by image formation. In contrast, when the weight average molecular weight of the polyurethane is more than 100,000, sensitivity tends to be inferior.

The content of the copolymer including an unsaturated carboxylic acid unit and/or an unsaturated carboxylic acid anhydride unit in the second image recording layer is preferably within a range from 10 to 100% by mass based on the solid content of the layer. When the content of the copolymer including an unsaturated carboxylic acid unit and/or an unsaturated carboxylic acid anhydride unit in the second image recording layer is less than 10% by mass, it is not preferred because it is disadvantageous in view of developing solution resistance.

On the other hand, the content of the copolymer including an unsaturated carboxylic acid unit and/or an unsaturated carboxylic acid anhydride unit or the polyurethane having a substituent containing an acidic hydrogen atom is preferably within a range from 2 to 90% by mass based on the solid content of the layer. When the content of the polyurethane having a substituent containing an acidic hydrogen atom is less than 2% by mass, it is disadvantageous in view of development speed. In contrast, when the content is more than 90% by mass, it is not preferred in view of storage stability. If necessary, two or more kinds of polyurethanes having a substituent containing an acidic hydrogen atom may be used in combination. Furthermore, two or more kinds of copolymers including an unsaturated carboxylic acid anhydride unit, copolymers including an unsaturated carboxylic acid unit or polyurethanes having a substituent containing an acidic hydrogen atom may be used in combination.

### <Photothermal Conversion Material>

The image recording layer can contain a photothermal conversion material. The photothermal conversion material means any substance capable of converting electromagnetic wave into thermal energy and is a substance having a maximum absorption wavelength within the near infrared to the infrared region, specifically a substance having a maximum absorption wavelength within a range from 760 nm to 1,200 nm. Examples of the substance include various pigments and dyes.

As the pigment which can be used in the present invention, there can be used commercially available pigments and pigments described in the Color Index Manual "Saishin Ganryou Binran" (New Manual of Pigments) (edited by the Japan Pigment Technology Association, 1977), "Saishin Ganryou Ouyou Gijutsu" (New Applied Technology for Pigment) (CMC Publishing, 1986) and "Insatsu Inki Gijutsu" (Printing Ink Technology) (CMC Publishing, 1984). The types of pigment include black pigments, yellow pigments, orange pigments, brown pigments, red pigments, violet pigments, blue pigments, green pigments, fluorescent pigments, and in addition, polymer bound coloring pigments. More specifically, there can be used insoluble azo pigments, azo lake pigments, condensed azo pigments, chelate azo pigments, phthalocyanine base pigments, anthraquinone base pigments, perylene and perinone base pigments, thioindigo base pigments, quinacridone base pigments, dioxazine base pigments, isoindolinone base pigments, quinophthalone base pigments, dye lake pigments, azine pigments, nitroso pigments, nitro pigments, natural pigments, fluorescent pigments, inorganic pigments and carbon black.

Of these specific examples, carbon black is particularly preferred as a substance which absorbs a near infrared to infrared ray laser beam to efficiently generate heat, and is economically competitive. At present, carbon blacks having various functional groups and having excellent dispersibility are commercially available and, for example, carbon blacks described in detail in "Carbon Black Manual, 3rd edition, (edited by the Carbon Black Association) 1995, p.167" and "Characteristics of Carbon Black and Optimal Formulation and Applied Technology (Technical Information Association) 1997, p.111" can be preferably used in the present invention.

These pigments may be used without surface treatment or may be subjected to a known surface treatment. As a known surface treating method, there can be used a method including surface-coating a resin or wax, a method which attaches a surfactant, and a method in which a reactive substance, such as a silane coupling agent or an epoxy compound, polyisocyanate, is bound to the surface of a pigment. These surface treating methods are described in "Kinzoku Sekken no Seishitsu to Ouyou" (Properties of Metal Soaps and Their Application) (Saiwai Shobo), "Saishin Ganryou Ouyou Gijutsu" (New Applied Technology for Pigment) (CMC Publishing, 1986), and "Insatsu Inki Gijutsu" (Printing Ink Technology) (CMC Publishing, 1984). The pigment used in the present invention preferably has a particle diameter within the range of 0.01 to 15 µm, and more preferably 0.01 to 5 µm.

As the dye which can be used in the present invention, there can be used any known conventional dye and there can be mentioned, for example, those described in "Senryou Binran" (Dye Manual) (edited by the Organic Synthesis Chemistry Association, 1970), "Shikizai Kougaku Handobukku" (Coloring Material Engineering Handbook) (edited by the Coloring Material Association, Asakura Shoten, 1989), "Kougyouyou Shikiso no Gijutsu to Shijyou" (Technology and Market of Industrial Coloring Matter) (edited by CMC, 1983), and "Kagaku Binran Ouyou Kagaku Hen" (Chemistry Manual Applied Chemistry Version) (edited by the Japan Chemistry Society, Maruzen Shoten, 1986). More specifically, there can be mentioned azo dyes, metal complex azo dyes, pyrazolone azo dyes, anthraquinone dyes, phthalocyanine dyes, carbonium dyes, quinoneimine dyes, methine dyes, cyanine dyes, indigo dyes, quinoline dyes, nitro dyes, xanthene dyes, thiazine dyes, azine dyes and oxazine dyes.

As dyes which absorb light of from the near infrared to the infrared region, for example, there can be used azo dyes, metal complex azo dyes, pyrazolone azo dyes, naphthoquinone dyes, anthraquinone dyes, phthalocyanine dyes, carbonium dyes, quinoneimine dyes, methine dyes, cyanine dyes, squalirium pigements, pyrylium salts and metal thiolate complexes (for example, nickelthiolate complex, etc.). Of these dyes, cyanine dyes are preferred and examples thereof include cyanine dyes represented by the general formula (I) disclosed in Japanese Unexamined Patent Publication (Kokai) No. 2001-305722 and compounds disclosed in paragraphs [0096] to [0103] of Japanese Unexamined Patent Publication (Kokai) No. 2002-079772.

The photothermal conversion materials are particularly preferably dyes of the following formulas: 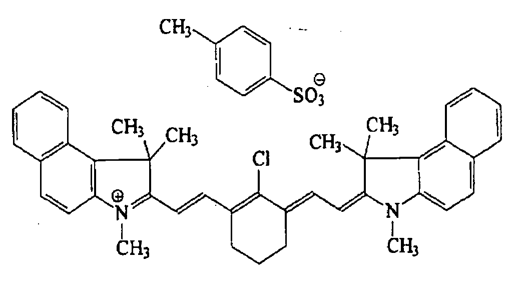 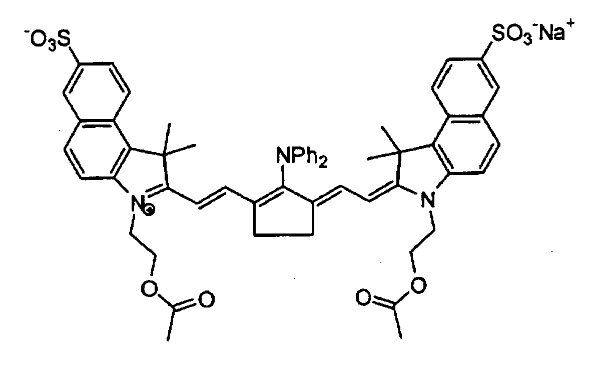 wherein Ph represents a phenyl group.

The photothermal conversion material can be added in the image recording layer in the amount of 0.01 to 50% by mass, preferably 0.1 to 25% by mass, and particularly preferably 1 to 20% by mass, based on the first and/or second image recording layers. When the amount is less than 0.01% by mass, sensitivity decreases. In contrast, when the amount is more than 50% by mass, smear may occur at the non-image areas upon printing. These photothermal conversion materials may be used alone or in combination of one or more.

The lithographic printing original plate of the present invention is produced by sequentially applying a solution or dispersion prepared by dissolving or dispersing components of the image recording layer in an organic solvent on a substrate, followed by drying to form an image recording layer on the substrate.

As the organic solvent in which components of the image recording layer are dissolved or dispersed, any known conventional ones can be used. Of these organic solvents, those having a boiling point of 40°C to 220°C, particularly 60°C to 160°C are selected in view of advantages during drying.

Examples of the organic solvent include alcohols such as methyl alcohol, ethyl alcohol, n- or iso-propyl alcohol, n- or iso-butyl alcohol and diacetone alcohol; ketones such as acetone, methyl ethyl ketone, methyl propyl ketone, methyl butyl ketone, methyl amyl ketone, methyl hexyl ketone, diethylketone, diisobutylketone, cyclohexanone, methylcyclohexanone and acetylacetone; hydrocarbons such as hexane, cyclohexane, heptane, octane, nonane, decane, benzene, toluene, xylene and methoxybenzene; acetate esters such as ethyl acetate, nor iso-propyl acetate, n- or iso-butyl acetate, ethylbutyl acetate and hexyl acetate; halides such as methylene dichloride, ethylene dichloride and monochlorobenzene; ethers such as isopropyl ether, n-butyl ether, dioxane, dimethyldioxane and tetrahydrofuran; polyhydric alcohols and derivatives thereof, such as ethylene glycol, ethylene glycol monomethyl ether, ethylene glycol monomethyl ether acetate, ethylene glycol monoethyl ether, ethylene glycol monoethyl ether acetate, ethylene glycol monobutyl ether, ethylene glycol monobutyl ether acetate, ethylene glycol dimethyl ether, ethylene glycol diethyl ether, ethylene glycol dibutyl ether, methoxyethoxyethanol, diethylene glycol monomethyl ether, diethylene glycol dimethyl ether, diethylene glycol methylethyl ether, diethylene glycol diethyl ether, propylene glycol, propylene glycol monomethyl ether, propylene glycol monomethyl ether acetate, propylene glycol monoethyl ether, propylene glycol monoethyl ether acetate, propylene glycol monobutyl ether, 3-methyl-3-methoxybutanol and 1-methoxy-2-propanol; and special solvents such as dimethyl sulfoxide, N,N-dimethylformamide, methyl lactate and ethyl lactate. These organic solvents are used alone or in combination. The solid content in the solution or dispersion to be applied is preferably adjusted within a range from 2 to 50% by mass. The solid content as used in the present invention means components excluding the organic solvent.

As the coating method of the solution or dispersion of components of the image recording layer, for example, there can be used roll coating, dip coating, air knife coating, gravure coating, gravure offset coating, hopper coating, blade coating, wire doctor coating, spray coating and die coating methods. The coating weight is preferably within a range from 10 ml/m² to 100 ml/m².

The solution or dispersion applied on the substrate is usually dried by heated air. The drying temperature (the temperature of heated air) is preferably within a range from 30°C to 220°C, and particularly preferably from 40°C to 160°C. As the drying method, not only a method of maintaining the drying temperature at a constant temperature during drying, but also a method of raising stepwise the drying temperature can be carried out.

Preferred results can also be obtained by dehumidifying drying air. The heated air is preferably supplied in the rate of 0.1 m/seconds to 30 m/seconds, and particularly preferably 0.5 m/seconds to 20 m/seconds, to the surface to be coated.

Usually, the coating weight of the image recording layer is independently within a range from about 0.1 to about 5 g/m² on dry mass basis.

### <Other Components of Image Recording Layer>

To the image recording layer of the lithographic printing original plate of the present invention, known additives, for example, colorants (dyes, pigments), surfactants, plasticizers, stability improvers, development accelerators, development inhibitors and lubricants (silicon powder, etc.) can be added, if necessary.

Examples of preferred dye include basic oil-soluble dyes such as crystal violet, malachite green, victoria blue, methylene blue, ethyl violet and rhodamine B. Examples of commercially available products include Victoria Pure Blue BOH" [manufactured by Hodagaya Kagaku Kogyo K.K.], "Oil Blue #603" [manufactured by Orient Chemical Industries, Ltd.], "VPB-Naps (naphthalene sulfonate of Victoria Pure Blue)" [manufactured by Hodagaya Kagaku Kogyo K.K.], "D11" [manufactured by PCAS]. Examples of the pigment include phthalocyanine blue, phthalocyanine green, dioxadine violet and quinacridone red.

Examples of the surfactant include fluorine base surfactants and silicone base surfactants.

Examples of the plasticizer include diethyl phthalate, dibutyl phthalate, dioctyl phthalate, tributyl phosphate, trioctyl phosphate, tricresyl phosphate, tri(2-chloroethyl)phosphate and tributyl citrate.

It is possible to use, as the known stability improver, phosphoric acid, phosphorous acid, oxalic acid, tartaric acid, malic acid, citric acid, dipicolic acid, polyacrylic acid, benzenesulfonic acid and toluenesulfonic acid in combination.

Examples of other stability improvers include known phenolic compounds, quinones, N-oxide compounds, amine base compounds, sulfide group-containing compounds, nitro group-containing compounds and transition metal compounds. Specific examples thereof include hydroquinone, p-methoxyphenol, p-cresol, pyrogallol, t-butyl catechol, benzoquinone, 4,4'-thiobis(3-methyl-6-t-butylphenol), 2,2'-methylenebis(4-methyl-6-t-butylphenol), 2-mercaptobenzimidazole and N-nitrosophenylhydroxyamine primary cerium salt.

Examples of the development accelerator include acid anhydrides, phenols and organic acids. Acid anhydrides are preferably cyclic acid anhydrides. As the cyclic acid anhydride, there can be used those described in the specification of U.S. Patent No. 4,115,128, for example, phthalic anhydride, tetrahydrophthalic anhydride, hexahydrophthalic anhydride, 3,6-endoxy-tetrahydrophthalic anhydride, tetrachlorophthalic anhydride, maleic anhydride, chloromaleic anhydride, α-phenylmaleic anhydride, succinic anhydride and pyromellitic anhydride. Examples of the non-cyclic anhydride include acetic anhydride. Examples of phenols include bisphenol A, 2,2'-bishydroxysulfon, p-nitrophenol, p-ethoxyphenol, 2,4,4'-trihydroxybenzophenone, 2,3,4-trihydroxybenzophenone, 4-hydroxybenzophenone, 4,4',4"-trihydroxytriphenylmethane and 4,4',3",4"-tetrahydroxy-3,5,3',5'-tetramethyltriphenylmethane.

Examples of organic acids include those described in Japanese Unexamined Patent Publication (Kokai) No. 60-88942 and Japanese Unexamined Patent Publication (Kokai) No. 2-96755, for example, sulfonic acids, sulfonic acids, alkylsulfuric acids, phosphonic acids, phosphate esters and carboxylic acids, and specific examples thereof include p-toluenesulfonic acid, dodecylbenzenesulfonic acid, p-toluenesulfinic acid, ethylsulfuric acid, phenylphosphonic acid, phenylphosphinic acid, phenyl phosphate, diphenyl phosphate, benzoic acid, isophthalic acid, adipic acid, p-toluic acid, 3,4-dimethoxybenzoic acid, phthalic acid, terephthalic acid, 4-cyclohexene-1,2-dicarboxylic acid, erucic acid, lauric acid, n-undecanoic acid and ascorbic acid.

The development inhibitor is not particularly limited as long as it causes an interaction with the alkali-soluble resin and substantially lowers solubility of the alkali-soluble resin in the developing solution in the unexposed areas, and also becomes soluble in the developing solution as a result of the weakened interaction in the exposed areas. In particular, quaternary ammonium salts and polyethylene glycol base compounds are used particularly preferably. Of the above infrared absorbers and colorants, some compounds function as the development inhibitor and are preferably exemplified. The development inhibitor further includes substances, which are heat-decomposable and substantially lowers solubility of the alkali-soluble resin in a non-decomposable state, for example, onium salts, o-quinonediazide compounds, aromatic sulfone compounds and aromatic sulfonate ester compounds.The amount of these various additives varies depending on the purposes, but is preferably within a range from 0 to 30% by mass based on the solid content of the image recording layer.

In addition, other alkali-soluble or dispersible resins can be optionally used in combination in the image recording layer of the lithographic printing original plate of the present invention. Examples of the other alkali-soluble or dispersible resin include copolymers of alkali-soluble group-containing monomers such as acrylic acid, methacrylic acid, maleic acid, maleic anhydride, itaconic acid and itaconic anhydride with other monomers, polyester resins and acetal resins.

In the lithographic printing original plate of the present invention, the image recording layer may contain matting agents for the purpose of improving interleaving paper peelability and improving plate transport properties of an automatic plate loader. Furthermore, in order to prevent scratching of a surface of an original printing plate, a protective layer may be disposed on the image recording layer, and the protective layer may contain a matting agent.

### <Exposure and Development>

The infrared-sensitive or thermosensitive lithographic printing original plate of the present invention can be used as a so-called computer-to-plate (CTP) plate which can directly write an image on a plate based on digital information from a computer.

As a laser light source in the present invention, a high-output laser having a maximum strength in the near infrared to the infrared region is used most preferably. Examples of the high-output laser having a maximum strength in the near infrared to the infrared region include various lasers having a maximum strength in the near infrared to the infrared region within a range from 760 nm to 1,200 nm, for example, semiconductor laser and YAG laser.

The positive working lithographic printing original plate of the present invention is applied to an image forming method in which an image is written on an image recording layer using laser and then subjected to a development treatment to remove the non-image region using a wet process. That is, according to the image forming method of the present invention, an image is formed thorough a step of image-wise exposing the lithographic printing original plate of the present invention; and a step of developing the exposed lithographic printing original plate to remove the exposed region, thus forming an image region composed of an image recording layer and a non-image region.

Examples of the developing solution used in the development treatment include an aqueous alkali solution (aqueous basic solution). The pH of the aqueous alkali solution used in the positive working lithographic printing original plate of the present invention is preferably lower pH (pH of 12 or lower). Specifically, the pH is preferably from 7 to 12, more preferably from 8 to 12, and particularly preferably from 10 to 12.

Examples of the alkali agent used in the developing solution include inorganic alkali compounds such as potassium hydroxide, sodium hydroxide, lithium hydroxide, sodium, potassium or ammonium salt of secondary or tertiary phosphoric acid, sodium metasilicate, sodium carbonate and ammonia; and organic alkali compounds such as monomethylamine, dimethylamine, trimethylamine, monoethylamine, diethylamine, triethylamine, monoisopropylamine, diisopropylamine, n-butylamine, di-n-butylamine, monoethanolamine, diethanolamine, triethanolamine, ethyleneimine and ethylenediamine.

The content of the alkali agent in the developing solution is preferably within a range from 0.005 to 10% by mass, and particularly preferably from 0.05 to 5% by mass. When the content of the alkali agent in the developing solution is less than 0.005% by mass, developability tends to becomes inferior. In contrast, when the content is more than 10% by mass, it is not preferred since an adverse influence such as erosion of the image areas tends to be exerted upon development.

To the developing solution, an organic solvent can also be added. Examples of the organic solvent, which can be added to the developing solution, include ethyl acetate, butyl acetate, amyl acetate, benzyl acetate, ethylene glycol monobutyl acetate, butyl lactate, butyl levulinate, methyl ethyl ketone, ethyl butyl ketone, methyl isobutyl ketone, cyclohexanone, ethylene glycol monobutyl ether, ethylene glycol monobenzyl ether, ethylene glycol monophenyl ether, benzyl alcohol, methyl phenyl carbitol, n-amyl alcohol, methylamyl alcohol, xylene, methylene dichloride, ethylene dichloride and monochlorobenzene. When the organic solvent is added to the developing solution, the amount of the organic solvent is preferably 20% by mass or less, and particularly preferably 10% by mass.

Furthermore, it is possible to optionally add water-soluble sulfites such as lithium sulfite, sodium, potassium sulfite and magnesium sulfite; hydroxyaromatic compounds such as alkali-soluble pyrazoline compound, alkali-soluble thiol compound and methylresolcin; water softeners such as polyphosphates and aminopolycarboxylic acids; anionic surfactants such as sodium isopropyl naphthalene sulfonate, sodium n-butyl naphthalene sulfonate, sodium N-methyl-N-pentadecyl aminoacetate and sodium lauryl sulfate; various surfactants such as nonionic surfactants, cationic surfactants, amphoteric surfactants and fluorine base surfactants; and various defoamers, in the developing solution.

The temperature of the developing solution is preferably within a range from 15 to 40°C, and the dipping time is preferably within a range from 1 to 120 seconds. If necessary, it is also possible to slightly rub the surface during development.

The developed lithographic printing plate is washed with water and then subjected to a treatment with a plate surface protective agent. The treatment with a plate surface protective agent is a so-called desensitizing treatment and is carried out for the purpose of protecting the non-image areas, preventing print smearing and protecting from scratch.

The plate surface protective agent used in the present invention is **characterized in that** it contains a starch having an onium group. The onium group is preferably an onium group in which an atom having a positive charge in the onium group is selected from a nitrogen atom, a phosphorus atom and a sulfur atom, particularly preferably a quaternary ammonium group in which an atom having a positive charge is a nitrogen atom, and particularly preferably a substituent of the following formula:

-Z-NR¹R²R³⁺X⁻

wherein R¹ and R² each independently represents a C₁-C₄ alkyl group which may have a substituent; R³ represents a hydrogen atom or a C₁-C₄ alkyl group which may have a substituent; X⁻ represents a counter anion; and Z represents a divalent organic group. Examples of the divalent organic group include an aliphatic group, an aromatic group, an alicyclic group, a heterocyclic group and an aroma-aliphatic group, and an aliphatic group is preferred. The aliphatic group is particularly preferably an alkylene group, and the alkylene group is preferably a C₁-C₁₀ alkylene group, more preferably a C₁-C₆ alkylene group, and particularly preferably a C₁-C₄ alkylene group. The alkylene group may be optionally substituted with one or more substituents, for example, a halogen atom such as fluorine, chlorine, bromine or iodine, a C₁-C₄ alkyl group, an amino group, a mono C₁-C₄ alkyl group substituted amino group or a di C₁-C₄ alkyl group substituted amino group.

The starch having an onium group, which is particularly preferred in the present invention, is represented by the formula shown below. Examples of the commercially available product include "Excell D-7" [manufactured by NIPPON STARCH CHEMICAL CO., LTD.] and "Petrosize U" [manufactured by NIPPON STARCH CHEMICAL CO., LTD.]. The amount of the starch in the plate surface protective agent is preferably from 0.1 to 30% by mass, and particularly preferably from 1 to 20% by mass.

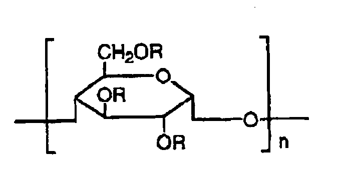

In the formula, R represents H or at least one R is -Z-NR¹R²R³⁺X⁻ in which R¹ and R² each independently represents a C₁-C₄ alkyl group which may have a substituent, R³ represents a hydrogen atom or a C₁-C₄ alkyl group which may have a substituent, X⁻ represents a counter anion, and Z represents a divalent organic group.

It is preferred to further add a water-soluble polymer compound having film-forming properties to the plate surface protective agent used in the present invention. Examples of the water-soluble polymer compound include acasia, cellulose derivatives (for example, carboxymethyl cellulose, carboxyethyl cellulose, methyl cellulose, hydroxypropyl cellulose, etc.) and modified substances thereof, polyvinyl alcohol and derivatives thereof, polyvinyl pyrrolidone, polyacrylamide and copolymers thereof, vinyl methyl ether/maleic anhydride copolymer, vinyl acetate/maleic anhydride copolymer, styrene/maleic anhydride copolymer, water-soluble soybean polysaccharides, starch derivatives (for example, dextrin, enzymatically hydrolyzed dextrin, hydroxypropylated starch enzymatically hydrolyzed dextrin, carboxydimethylated starch, phosphorylated starch, cyclodextrin, etc.), pullulan and pullulan derivatives, and hemicellulose extracted from soybean. The content of these water-soluble polymers is preferably from 0.1 to 30% by mass, and particularly preferably from 1 to 20% by mass.

The plate surface protective agent used in the present invention may contain surfactants. Preferred surfactants are nonionic surfactants and cationic surfactants which are less likely to cause an interaction with onium groups in the starch.

Examples of the nonionic surfactant include polyoxyethylene alkyl ethers, polyoxyethylene alkyl phenyl ethers, polyoxyethylene polystyryl phenyl ether, polyoxyethylene polyoxypropylene alkyl ether, glycerin fatty acid partial esters, sorbitan fatty acid partial esters, pentaerythritol fatty acid partial esters, propylene glycol monofatty acid ester, sucrose fatty acid partial ester, polyoxyethylene sorbitan fatty acid partial esters, polyoxyethylene sorbitol fatty acid partial esters, polyethylene glycol fatty acid esters, polyglycerin fatty acid partial esters, polyoxyethylenated castor oils, polyoxyethylene glycerin fatty acid partial esters, fatty acid diethanolamides, N,N-bis-2-hydroxyalkylamines, polyoxyethylenealkylamine, triethanolamine fatty acid ester, trialkylamine oxide, polypropylene glycol having a molecular weight of 200 to 5,000, trimethylolpropane, polyoxyethylene of glycerin or sorbitol, or an adduct of polyoxypropylene, and acetylene glycol.

Examples of the cationic surfactant include a quaternary ammonium salt such as trimethylbenzylammonium chloride. The anionic surfactant is useful for improvement of inking properties or coater coatability. Examples of a specific compound of the anionic surfactant, which can be used in the present invention, include fatty acid salts, abietates, hydroxyalkane sulfonates, alkane sulfonates, dialkyl sulfosuccinates, linear alkyl benzene sulfonates, branched chain alkyl benzene sulfonates, alkyl naphthalene sulfonate, alkyl phenoxypolyoxyethylene propyl sulfonate, polyoxyethylene alkyl sulfophenyl ether salts, N-methyl-N-oleyltaurins sodium salts, N-alkyl sulfosuccinic acid monoamide disodium salts, petroleum sulfonate salts, sulfated castor oil, sulfated beef tallow, sulfuric acid ester salts of fatty acid alkyl esters, alkylsulfuric acid ester salts, polyoxyethylene alkyl ether sulfuric acid ester salts, fatty acid monoglycride sulfate ester salts, polyoxyethylene alkylphenyl ether sulfuric acid ester salts, polyoxyethylene styryl phenyl ether sulfuric acid ester salts, alkylphosphoric acid ester salts, polyoxyethylene alkyl ether phosphoric acid ester salts, polyoxyethylene alkyl phenyl ether phosphoric acid ester salts, partially saponified substances of styrene-maleic anhydride copolymers, partially saponified substances of olefin-maleic anhydride copolymers and naphthalenesulfonic acid salt formalin condensates. These surfactants can be used in combination of two or more. The amount of the surfactant is preferably from 0.01 to 20% by mass, and particularly preferably from 0.1 to 10% by mass, based on the total amount of the plate surface protective agent.

Furthermore, organic solvents may be added to the plate surface protective agent used in the present invention so as to improve inking properties of the image areas. Examples of solvents include alcohols, ketones, esters and polyhydric alcohols.

Examples of alcohols include n-hexanol, 2-ethylbutanol, n-heptanol, 2-heptanol, 3-heptanol, 2-octanol, 2-ethylhexanol, 3,5,5-trimethylhexanol, nonanol, n-decanol, undecanol, n-dodecanol, tetradecanol, heptadecanol, trimethylnonyl alcohol, cyclohexanol, benzyl alcohol and tetrahydrofurfuryl alcohol.

Examples of ketones include methyl-n-amyl ketone, methyl-n-hexyl ketone, ethyl-n-butyl ketone, di-n-propyl ketone, diacetone alcohol and cyclohexanone.

Examples of esters include n-amyl acetate, isoamyl acetate, methylisoamyl acetate, methoxybutyl acetate, benzyl acetate, ethyl lactate, butyl lactate, n-amyl lactate, methyl benzoate, ethyl benzoate, dimethyl phthalate, diethyl phthalate, dibutyl phthalate, di-2-ethylhexyl phthalate and dioctyl phthalate.

Examples of polyhydric alcohols and derivatives thereof include ethylene glycol, ethylene glycol monomethyl ether acetate, ethylene glycol monoethyl ether acetate, ethylene glycol butyl ether, ethylene glycol dibutyl ether, ethylene glycol isoamyl ether, ethylene glycol monophenyl ether, ethylene glycol monophenyl ether acetate, ethylene glycol benzyl ether, ethylene glycol monohexyl ether, methoxyethanol, diethylene glycol, diethylene glycol monomethyl ether, diethylene glycol monoethyl ether, diethylene glycol monobutyl ether, diethylene glycol monobutyl ether acetate, diethylene glycol dimethyl ether, diethylene glycol diethyl ether, diethylene glycol dibutyl ether, triethylene glycol, triethylene glycol monomethyl ether, triethylene glycol monoethyl ether, tetraethylene glycol, polyethylene glycol, propylene glycol, dipropylene glycol, propylene glycol monoethyl ether, propylene glycol monobutyl ether, 1-butoxyethoxypropanol, dipropylene glycol, dipropylene glycol monomethyl ether, dipropylene glycol monoethyl ether, tripropylene glycol monomethyl ether, tripropylene glycol monobutyl ether, octylene glycol, 2-ethyl-1,3-hexanediol, 1,6-hexanediol, 2,5-hexanediol, 3,4-hexanediol, 1,8-octanediol, 1,9-nonanediol, 1,10-decanediol, glycerin, glycerin monoacetate, glycerin triacetate and sorbitol.

Also, acids can be added for the purpose of pH adjustment and hydrophilication. Examples of the mineral acid include phosphoric acid, nitric acid and sulfuric acid. Examples of the organic acid include citric acid, acetic acid, oxalic acid, phosphonic acid, malonic acid, p-toluenesulfonic acid, tartaric acid, malic acid, lactic acid, levulinic acid, phytic acid, organic phosphonic acid, tannic acid and silicic acid. Examples of the inorganic salt include magnesium nitrate and nickel sulfate. Mineral acids, organic acids and inorganic salts may be used alone or in combination of one or more. The amount is preferably from 0.1 to 10% by mass.

In addition to the above components, chelating agents may be optionally added. Usually, the plate surface protective agent is commercially available as a concentrated solution and is diluted with tap water or well water before use. Since calcium ions contained in tap water or well water used for dilution may exert an adverse influence on printing to cause smearing of a printed matter, it is possible to overcome the above drawbacks by adding chelating compounds.

Examples of the chelating agent include acids such as ethylenediaminetetraacetic acid, diethylenetriaminepentaacetic acid, triethylenetetraminehexaacetic acid, hydroxyethylethylenediaminetriacetic acid, nitrilotriacetic acid, 1-hydroxyethane-1,1-diphosphonic acid, aminotri(methylenephosphonic acid), ethylenediaminetetra(methylenephosphonic acid), diethylenetriaminepenta(methylenephosphonic acid), triethylenetetraminehexa(methylenephosphonic acid) and hydroxyethylethylenediaminetri(methylenephosphonic acid), and potassium salt, sodium salt and amine salt thereof. As the chelating agent, those which stably exist in the plate surface protective agent and do not inhibit printability are selected. The amount is preferably from 0.01 to 10% by mass based on the plate surface protective agent when used.

In addition, additives such as antiseptics and defoamers may be added to the plate surface protective agent of the present invention. Examples of the antiseptic include phenol or derivatives thereof, formalin, phenolformalin, imidazole derivatives, sodium dehydroacetate, 4-isothiazolin-3-one derivatives, benzointhiazolin-3-one, benztriazole derivatives, amidineguanidine derivatives, quaternary ammonium salts, pyridine, quinoline, guanidine, dieazine, triazole derivatives, oxazole, oxazine derivatives, nitroalcohol derivatives, benzoic acid or derivatives thereof. A preferred amount is the amount which stably exerts the effect against bacteria, molds and yeasts and varies depending on the kind of bacteria, molds and yeasts, but is preferably within a range from 0.001 to 1% by mass based on the plate surface protective agent and two or more kinds of antiseptics are preferably used in combination so as to exert the effect against various molds and sterilization. The defoamer is preferably a silicone defoamer. Of these defoamers, emulsion dispersion types and solubilized deforamers can be used. The amount is preferably within a range from 0.001 to 1% by mass based on the plate surface protective agent. After subjecting to a treatment with a plate surface protective agent, the lithographic printing plate is dried and then used for printing as a printing plate.

### EXAMPLES

The present invention will be described in more detail by way of Examples. However, the present invention is not limited to these Examples.

### Synthesis Example of Water-Soluble Resin for Intermediate Layer Treatment

### <Synthesis Example 1>

### Copolymer of Vinylphosphonic acid and Methacrylic Acid

In a 10 liter flask equipped with a stirrer, a condenser and a dropping device, 3,500 g of ethyl acetate was charge and heated to 70°C. 390 g (3.61 mol) of a vinylphosphonic acid monomer, 1,243 g (14.44 mol) of methacrylic acid and 52 g of AIBN were dissolved in 1,000 g of ethyl acetate and the resultant solution was added dropwise in a reactor over 4 hours. During dropwise addition of the monomer solution, a white precipitate was produced. After heating with stirring for 2 hours while maintaining at 70°C, heating was stopped, followed by cooling to room temperature. The resultant precipitate was collected by vacuum filtration, washed with 1,000 g of ethyl acetate and then vacuum-dried at 40°C for 24 hours to obtain a "polymer 1" as a white microcrystal (yield: 1,550 g).

### <Synthesis Example 2>

### Copolymer of Ethylene Glycol Methacrylate Phosphate (Phosmer M) and Methacrylic Acid

In a 10 liter flask equipped with a stirrer, a condenser and a dropping device, 3,500 g of ethyl acetate was charged and then heated to 70°C. 758.1 g (3.61 mol) of Phosmer M, 1,243 g (14.44 mol) of methacrylic acid and 52 g of AIBN were dissolved in 1,000 g of ethyl acetate and the resultant solution was added dropwise in a reactor over 4 hours. During dropwise addition of the monomer solution, a white precipitate was produced. After heating with stirring for 2 hours while maintaining at 70°C, heating was stopped, followed by cooling to room temperature. The resultant precipitate was collected by vacuum filtration, washed with 1,000 g of ethyl acetate and then vacuum-dried at 40°C for 24 hours to obtain a "polymer 2" as a white microcrystal (yield: 1,900 g).

### Production of Substrate

### <Substrate 1>

A 0.24 mm thick aluminum plate was degreased in an aqueous sodium hydroxide solution and then subjected to an electrolytic graining treatment in a 20% hydrochloric acid bath to obtain a grained plate having a center line average roughness (Ra) of 0.5 µm. Then, the grained plate was subjected to an anodizing treatment in a 20% hydrochloric acid bath at a current density of 2 A/dm² to form an oxide film (2.7 g/m²). After washing with water and drying, an aluminum substrate was obtained. The substrate thus obtained was immersed in an aqueous 0.5 wt% solution of a polymer 1 heated to 60°C for 10 seconds. The substrate was washed with water, squeeged and then dried to obtain a substrate 1.

### <Substrate 2>

A 0.24 mm thick aluminum plate was degreased in an aqueous sodium hydroxide solution and then subjected to an electrolytic graining treatment in a 20% hydrochloric acid bath to obtain a grained plate having a center line average roughness (Ra) of 0.5 µm. Then, the grained plate was subjected to an anodizing treatment in a 20% hydrochloric acid bath at a current density of 2 A/dm² to form an oxide film (2.7 g/m²). After washing with water and drying, an aluminum substrate was obtained. The substrate thus obtained was immersed in an aqueous 0.5 wt% solution of a polymer 2 heated to 60°C for 10 seconds. The substrate was washed with water, squeeged and then dried to obtain a substrate 2.

### <Substrate 3 (Comparative) 1>

A 0.24 mm thick aluminum plate was degreased in an aqueous sodium hydroxide solution and then subjected to an electrolytic graining treatment in a 20% hydrochloric acid bath to obtain a grained plate having a center line average roughness (Ra) of 0.5 µm. Then, the grained plate was subjected to an anodizing treatment in a 20% hydrochloric acid bath at a current density of 2 A/dm² to form an oxide film (2.7 g/m²). After washing with water and drying, an aluminum substrate (substrate 3) was obtained.

### Synthesis of Binder Resin

### <Resin Synthesis Example>

In a 10 liter flask equipped with a stirrer, a condenser and a dropping device, 2,990 g of dimethylacetamide was charged and then heated to 90°C. 740.5 g of phenylmaleimide, 1,001 g of methacrylamide, 368 g of methacrylic acid, 643 g of acrylonitrile, 203.6 g of Phosmer M (manufactured by Uni-Chemical Co., Ltd.), 222.5 g of styrene, 10.6 g of AIBN and 16 g of dimethylmercaptan were dissolved in 2,670 g of dimethylacetamide, and the resultant solution was added dropwise in a reactor over 2 hours. After completion of the dropwise addition, 5.3 g of AIBN was added and the temperature was raised to 100°C, followed by stirring for 4 hours. During stirring, 5.3 g of AIBN was added every 1 hour and the reaction was carried out.

After completion of the reaction, heating was stopped, followed by cooling to room temperature. The reaction solution was dropped in 50 liter of water and the resultant precipitate was collected by vacuum filtration, washed once with water and then collected again by vacuum filtration. After vacuum-drying at 50°C for 24 hours, 2,873 g (yield: 90%) of a binder resin 1 was obtained.

### Preparation of Coating Solution for First Image Recording Layer

A coating solution 1 for an image recording layer (first image recording layer) of a photosensitive composition shown in Table 1 was prepared.

**Table 1: Composition of coating solution 1 of image recording layer (first image recording layer)**

| Components | Unit: g |
|---|---|
| Methyl ethyl ketone | 47.28 |
| Propylene glycol monomethyl ether | 28.37 |
| γ-butyrolactone | 9.46 |
| Water | 9.46 |
| Binder resin 1 | 3.95 |
| Cyanine dye A | 0.50 |
| Cyanine dye B | 0.40 |
| Colorant dye A | 0.10 |
| Paintad 19 (silicone-based surfactant, manufactured by Dow Corning Toray Co., Ltd.) | 0.05 |

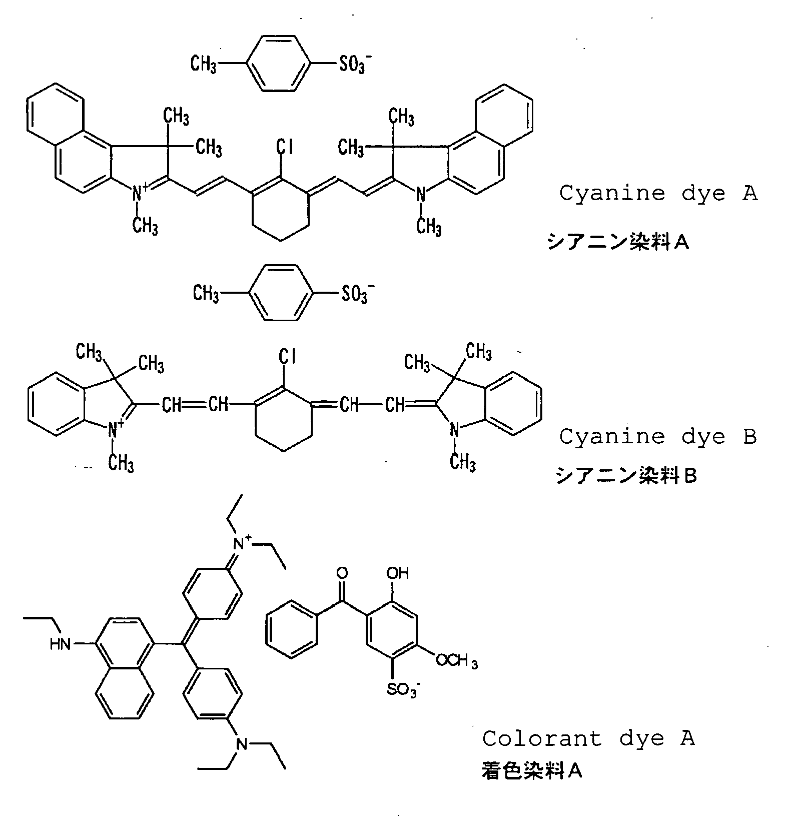

### Preparation of Coating Solution for Second Image Recording Layer

A coating solution 1 for an image recording layer (second image recording layer) of a photosensitive composition shown in Table 2 was prepared.

**Table 2: Composition of coating solution 2 for image recording layer (second image recording layer)**

| Components | Unit: g |
|---|---|
| Methyl isobutyl ketone | 66.32 |
| Acetone | 19.00 |
| Propylene glycol monomethyl ether acetate | 9.50 |
| Styrene maleic anhydride resin (average molecular weight: 2,000) | 4.93 |
| Colorant dye A | 0.02 |
| Paintad 19 (silicone-based surfactant, manufactured by Dow Corning Toray Co., Ltd.) | 0.05 |

The coating solution 1 for an image recording layer of the sensitizing solution composition prepared as shown in Table 1 was applied on the substrate obtained in Example 1 and Comparative Example 1 using a roll coater and then dried at 100°C for 2 minutes to obtain a first image recording layer. At this time, the amount of a dried coating film was 1.5 g/m². Subsequently, the coating solution 2 for an image recording layer prepared as shown in Table 2 was applied on the first image recording layer using a roll coater and then dried at 100°C for 2 minutes to obtain a two-layered lithographic printing original plate. Only the second image recording layer was removed by methyl isobutyl ketone and the amount of the dried coating film of the second image recording layer was determined. The amount of the dried coating film of the second image recording layer was 0.5 g/m².

### Preparation of Developing Solution

A developing solution was prepared according to the formulation shown in Table 3. The pH was 11.5 and electric conductivity was 12 mS/cm.

**Table 3: Composition of developing solution**

| Components | (ml) |
|---|---|
| Deionized water | 700 |
| Monoethanolamine | 10 |
| Diethanolamine | 30 |
| Perex NBL (sodium alkylnaphthalene sulfonate, manufactured by Kao Corporation) | 200 |
| Benzyl alcohol | 60 |

### Preparation of Plate Surface Protective Solution

In Table 4, the formulation of the plate surface protective solution is shown.

**Table 4**

| Components | Protective solution 1 | Protective solution 2 | Protective solution 3 | Protective solution 4 | Protective solution 5 |
|---|---|---|---|---|---|
| Deionized water | 93.45 | 93.45 | 93.45 | 93.45 | 93.45 |
| Amycol No. 3 (dextrin, manufactured by NIPPON STARCH CHEMICAL CO., LTD.) | 3.00 | 3.00 | 3.00 | 3.00 | 6.00 |
| Petrosize U (quternary ammonium alkyl etherified starch, manufactured by NIPPON STARCH CHEMICAL CO., LTD.) | 3.00 | 0.00 | 0.00 | 1.00 | 0.00 |
| Excell D-7 (quternary ammoniumalkyl etherified starch, manufactured by NIPPON STARCH CHEMICAL CO., LTD.) | 0.00 | 3.00 | 0.00 | 1.00 | 0.00 |
| Cj-5320 (tertiary ammonium alkyl etherified starch, manufactured by nippon starch chemical co., ltd.) | 0.00 | 0.00 | 3.00 | 1.00 | 0.00 |
| Phosphoric acid | 1.00 | 1.00 | 1.00 | 1.00 | 1.00 |
| Diammonium hydrogenphosphate | 2.00 | 2.00 | 2.00 | 2.00 | 2.00 |
| Perex NBL (sodium alkylnaphthalene sulfonate, manufactured by Kao Corporation) | 0.20 | 0.20 | 0.20 | 0.20 | 0.20 |
| Silicone KS-502 (silicone-based defoamer, manufactured by Shin-Etsu chemical Co., Ltd.) | 0.05 | 0.05 | 0.05 | 0.05 | 0.05 |

The resultant two-layered lithographic printing original plate (substrate 1, substrate 2, substrate 3) was exposed at 150 mJ/cm² using PT-R4300 (manufactured by Dainippon Screen Mfg. Co., Ltd.), developed with a developing solution prepared by diluting one part of developing solution 1 with four parts of water (5 times) at 30°C for 15 seconds using an automatic processor P-1310X (manufactured by Kodak's Graphic Communications) and then subjected to gum coating with a plate surface protective solution of protective solutions 1 to 5 to obtain a lithographic printing plate.

### <Evaluation>

Using the resultant lithographic printing plate, printing machine (Roland 201 printing machine: manufactured by Roland), a coated paper, printing ink (Space Color Fusion G Deep Red: manufactured by Dainippon Ink and Chemicals, Incorporated) and dampening-water (NA-108W concentration of 1%: manufactured by Dainippon Ink and Chemicals, Incorporated, IPA1%), printing was carried out. Restart toning recovery properties were evaluated by the following procedure.

First, 1,000 sheets were printed and printing was stopped in a state where the ink adheres to a surface of the plate. After heating the surface of the plate with hot air for 30 minutes, printing was restarted. Printing was carried out until deposition of the ink (smear) was removed and the number of sheets when deposition of ink was completely removed (number of sheets required for recovery) was recorded.

**Table 5* Results of printing test**

| | Example of substrate | Example of plate surface protective solution | Number of sheets required for recovery of restart toning |
|---|---|---|---|
| Example 1 | Substrate 1 | Plate surface protective solution 1 | less than 100 sheets |
| Example 2 | Substrate 1 | Plate surface protective solution 2 | less than 100 sheets |
| Example 3 | Substrate 1 | Plate surface protective solution 3 | less than 100 sheets |
| Example 4 | Substrate 1 | Plate surface protective solution 4 | less than 100 sheets |
| Example 5 | Substrate 2 | Plate surface protective solution 1 | less than 100 sheets |
| Example 6 | Substrate 2 | Plate surface protective solution 2 | less than 100 sheets |
| Example 7 | Substrate 2 | Plate surface protective solution 3 | less than 100 sheets |
| Example 8 | Substrate 2 | Plate surface protective solution 4 | less than 100 sheets |
| Comparative Example 1 | Substrate 1 | Plate surface protective solution 5 | 300 to 400 sheets |
| Comparative Example 2 | Substrate 2 | Plate surface protective solution 5 | 300 to 400 sheets |
| Comparative Example 3 | Substrate 3 | Plate surface protective solution 1 | not recovered (more than 400 sheets) |
| Comparative Example 4 | Substrate 3 | Plate surface protective solution 2 | not recovered (more than 400 sheets) |
| Comparative Example 5 | Substrate 3 | Plate surface protective solution 3 | not recovered (more than 400 sheets) |
| Comparative Example 6 | Substrate 3 | Plate surface protective solution 4 | not recovered (more than 400 sheets) |
| Comparative Example 7 | Substrate 3 | Plate surface protective solution 5 | not recovered (more than 400 sheets) |

## Claims

1. A method for plate-making of a lithographic printing original plate comprising an intermediate layer containing a polymer having a phosphonic acid group or a phosphoric acid group disposed between a substrate and an image recording layer, the method comprising the steps of:
image-wise exposing the lithographic printing original plate, developing, and treating using a plate surface protective solution containing a starch having an onium group.

2. The method according to claim 1, wherein the lithographic printing original plate is an infrared-sensitive positive working lithographic printing original plate.

3. The method according to claim 1 or 2, wherein the onium group is a quaternary ammonium group.

4. The method according to claim 3, wherein the starch having a quaternary ammonium group has the following structure: 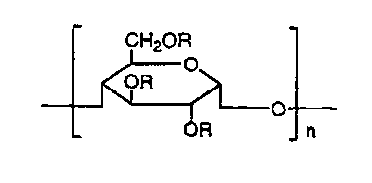 wherein R represents H or at least one R is -Z-NR¹R²R³⁺X⁻ in which R¹ and R² each independently represents a C₁-C₄ alkyl group which may have a substituent, R³ represents a hydrogen atom or a C₁-C₄ alkyl group which may have a substituent, X⁻ represents a counter anion and Z represents a divalent organic group.

5. The method according to any one of claims 1 to 4, wherein the development step is carried out using an aqueous solution of pH 12 or lower.
